# EUROPEAN PATENT APPLICATION

(11) **EP 4 531 044 A2**
(43) Date of publication of application: **02.04.2025**
(21) Application number: 24197049.0
(22) Date of filing: 28.08.2024
(51) Int. Cl.: G11C 5/04, H01L 21/48, H01L 23/498, H01L 23/538, H01L 23/00, H01L 25/00, H01L 23/367, H01L 23/373

(54) **SELF-ALIGNMENT ASSISTED ASSEMBLY ON A STRUCTURAL WAFER FOR HYBRID BONDED DIE STACKS**

(30) Priority: 28.09.2023 US 202318374516
(71) Applicant: Intel Corporation, Santa Clara, CA 95054 (US)
(72) Inventor: EID, Feras, Chandler, 85226 (US); SOUNART, Thomas, Chandler, 85226 (US); SHI, Yi, Chandler, 85248 (US); BAKER, Michael, Gilbert, 85297 (US); ELSHERBINI, Adel, Chandler, 85248 (US); JUN, Kimin, Portland, 97229 (US); BRUN, Xavier, Chandler, 85224 (US); LI, Wenhao, Chandler, 85226 (US)
(74) Representative: 2SPL Patentanwälte PartG mbB

(57) **Abstract**

Hybrid bonded die stacks, related apparatuses, systems, and methods of fabrication are disclosed. An integrated circuit (IC) die backside surface and a surface of a structural substrate each include bonding regions surrounded by hydrophobic structures. A liquid droplet is applied to the die or structural substrate bonding region and the die is placed on the bonding region of the structural substrate. Capillary forces cause the die to self-align to the bonding region, and a bond is formed by evaporating the liquid and subsequent anneal. A hybrid bond is then formed between the opposing active surface of the die and a base substrate using wafer-to-wafer bonding. IC structures including the IC die and portions of the structural substrate and base substrate are segmented from the bonded wafers and assembled.

## Description

### BACKGROUND

The integrated circuit industry is continually striving to produce ever faster, smaller, and more efficient integrated circuit devices, packages, and systems for use in various electronic products. Current die stacks can be formed using solder to solder bump attachment techniques. For example, on two separate dies, solder bumps may be deposited on copper pillars. The solder bumps may then be brought into contact to join the dies, and underfill material may be formed between the solder bonds and copper pillars. Such processes disadvantageously necessitate a large distance between the bonded dies.

Alternatively, hybrid bonds may be formed between corresponding metallic bond pads on the two dies, with the metallic bond pads interspersed among dielectric material (e.g., an oxide). Prior to bonding, the surface of each die may be controlled to promote bonding by providing a recess of the metallic bond pads relative to the dielectric material, having the dielectric material be planar and relatively smooth, and others. The dies, having mirror image bond pads, are then brought together such that corresponding metallic bond pads and corresponding dielectric material surfaces of the two dies interface with one another. At room temperature, the dielectric materials adhere sufficiently to one another (due to Van der Waals forces) to maintain a bond. A high temperature anneal is then performed to bond the corresponding metallic bond pads, and to improve the dielectric material bond. Such processes reduce the distance between the bonded dies, reduce pitches between the metal bonds, and offer other advantages. For example, solder bump techniques may be limited to pitches of about 30 µm while hybrid bonding can attain less than 10 µm and even less than 1 µm pitches.

However, difficulties in forming 3D die stacks using hybrid bonding techniques persist. It is with respect to these and other considerations that the present improvements have been needed. Such improvements may become critical as the desire to provide improved integrated circuit devices, packages, and systems becomes more widespread.

### BRIEF DESCRIPTION OF THE DRAWINGS

The material described herein is illustrated by way of example and not by way of limitation in the accompanying figures. For simplicity and clarity of illustration, elements illustrated in the figures are not necessarily drawn to scale. For example, the dimensions of some elements may be exaggerated relative to other elements for clarity. Further, where considered appropriate, reference labels have been repeated among the figures to indicate corresponding or analogous elements. In the figures:
FIG. 1 provides a flow diagram illustrating an example process for fabricating integrated circuit (IC) structures inclusive of 3D die stacks with backsides of IC dies being attached to a structural substrate followed the frontsides of the IC dies being hybrid bonded to a base substrate;
FIGS. 2, 3, 4A, 4B, 4C, 4D, and 4E are illustrations of cross-sectional side views of IC structures being prepared for self-alignment bonding;
FIG. 4F illustrates a top-down view of the IC structure of FIG. 4E showing bonding regions defined by a hydrophobic pattern;
FIGS. 5, 6, 7, 8, and 9 are illustrations of cross-sectional side view of IC structures during self-alignment bonding and hybrid bonding;
FIG. 10 is an illustration of a cross-sectional side view of an assembly structure similar to the IC structure of FIG. 9 after packaging and deployment of heat removal solutions;
FIG. 11 illustrates exemplary systems deploying a 3D die stack including a die backside bonded to a structural substrate using hydrophobic containment features and frontside hybrid bonded to a base substrate; and;
FIG. 12 is a functional block diagram of an electronic computing device, all arranged in accordance with at least some implementations of the present disclosure.

### DETAILED DESCRIPTION

One or more embodiments or implementations are now described with reference to the enclosed figures. While specific configurations and arrangements are discussed, it should be understood that this is done for illustrative purposes only. Persons skilled in the relevant art will recognize that other configurations and arrangements may be employed without departing from the spirit and scope of the description. It will be apparent to those skilled in the relevant art that techniques and/or arrangements described herein may also be employed in a variety of other systems and applications other than what is described herein.

Reference is made in the following detailed description to the accompanying drawings, which form a part hereof, wherein like numerals may designate like parts throughout to indicate corresponding or analogous elements. It will be appreciated that for simplicity and/or clarity of illustration, elements illustrated in the figures have not necessarily been drawn to scale. For example, the dimensions of some of the elements may be exaggerated relative to other elements for clarity. Further, it is to be understood that other embodiments may be utilized, and structural and/or logical changes may be made without departing from the scope of claimed subject matter. It should also be noted that directions and references, for example, up, down, top, bottom, over, under, and so on, may be used to facilitate the discussion of the drawings and embodiments and are not intended to restrict the application of claimed subject matter. Therefore, the following detailed description is not to be taken in a limiting sense and the scope of claimed subject matter defined by the appended claims and their equivalents.

In the following description, numerous details are set forth. However, it will be apparent to one skilled in the art, that the present invention may be practiced without these specific details. In some instances, well-known methods and devices are shown in block diagram form, rather than in detail, to avoid obscuring the present invention. Reference throughout this specification to "an embodiment" or "one embodiment" means that a particular feature, structure, function, or characteristic described in connection with the embodiment is included in at least one embodiment of the invention. Thus, the appearances of the phrase "in an embodiment" or "in one embodiment" in various places throughout this specification are not necessarily referring to the same embodiment of the invention. Furthermore, the particular features, structures, functions, or characteristics may be combined in any suitable manner in one or more embodiments. For example, a first embodiment may be combined with a second embodiment anywhere the particular features, structures, functions, or characteristics associated with the two embodiments are not mutually exclusive.

As used in the description of the invention and the appended claims, the singular forms "a", "an" and "the" are intended to include the plural forms as well, unless the context clearly indicates otherwise. It will also be understood that the term "and/or" as used herein refers to and encompasses any and all possible combinations of one or more of the associated listed items.

The terms "coupled" and "connected," along with their derivatives, may be used herein to describe structural relationships between components. It should be understood that these terms are not intended as synonyms for each other. Rather, in particular embodiments, "connected" may be used to indicate that two or more elements are in direct physical or electrical contact with each other. "Coupled" may be used to indicated that two or more elements are in either direct or indirect (with other intervening elements between them) physical or electrical contact with each other, and/or that the two or more elements co-operate or interact with each other (e.g., as in a cause an effect relationship).

The terms "over," "under," "between," "on", and/or the like, as used herein refer to a relative position of one material layer or component with respect to other layers or components. For example, one layer disposed over or under another layer may be directly in contact with the other layer or may have one or more intervening layers. Moreover, one layer disposed between two layers may be directly in contact with the two layers or may have one or more intervening layers. In contrast, a first layer "on" a second layer is in direct contact with that second layer. Similarly, unless explicitly stated otherwise, one feature disposed between two features may be in direct contact with the adjacent features or may have one or more intervening features. The term immediately adjacent indicates such features are in direction contact. Furthermore, the terms "substantially," "close," "approximately," "near," and "about," generally refer to being within +/- 10% of a target value. The term layer as used herein may include a single material or multiple materials. As used in throughout this description, and in the claims, a list of items joined by the term "at least one of" or "one or more of" can mean any combination of the listed terms. For example, the phrase "at least one of A, B or C" can mean A; B; C; A and B; A and C; B and C; or A, B and C.

Integrated circuit structures, 3D die stack structures, devices, apparatuses, systems, and methods are described herein related to 3D die stacks assembled on a structural wafer.

As described above, hybrid bonding techniques offer advantages in the assembly of 3D die stacks. As used herein, the term 3D die stack indicates a stack of devices or structures having at least partially vertically aligned layers such that layers of the 3D die stack may employ one or more IC dies each. The term layer of a 3D die stack indicates a horizontal portion of the 3D die stack that includes only one depth of device within the horizontal portion (e.g., each layer may have any number of IC dies in the horizontal plane). The term IC die includes any monolithic integrated device that provides electrical, compute, memory, or similar functionality. IC dies include chiplets, chiplet dies, memory dies, processor dies, routing dies, and so on. Herein, the terms chiplet and IC die are used interchangeably. An IC die may be passive such that it only includes electrical routing, or it may be active such that it includes electrical devices such as transistors, capacitors, etc. The term base substrate, base wafer, or base die indicates a substrate having active or passive electrical features. In contrast, the term structural substrate, structural wafer, or structural die indicates a substrate absent any active or passive electrical features. For example, a structural substrate may be a monolithic material such as silicon, or other base material that provides structural support and heat removal. In some embodiments, an IC die may be an integral part of a wafer during hybrid bonding processing, and the IC die and other components may be diced from the wafer after bonding or other hybrid bonding processing, and assembled into an electronic device.

In the context of hybrid bonding of IC dies, faster throughput may be attained during die- to-wafer hybrid bonding (D2W HB) using self-alignment assisted assembly (SA3). In SA3 process flows, a liquid droplet is dispensed on the bonding area on either the top chiplet die or the base wafer to be bonded. A bonder is then used to pick and place the chiplet die onto the base wafer at coarse alignment (e.g., ~ 25-50 um), such that the water droplet is sandwiched in the bonding area between the chiplet and the base wafer. Capillary forces cause the chiplet to self-align to its desired bonding location on the wafer with high positional accuracy (e.g., < 200 nm) due to containment features (e.g., SA3 features) designed into the chiplet die and base wafer that confine the droplet to the bonding area with high precision. Such containment features may be characterized as alignment features, SA3 features, or the like. The liquid then evaporates, leaving the chiplet bonded to the base wafer at room temperature due to attractive surface forces (e.g., Van der Waals forces) between the dielectric regions on the chiplet and base wafer. An annealing step is then carried out to form and/or strengthen bonds between the metal pads (e.g., copper pads) dispersed between the dielectric regions, forming electrical interconnects between the chiplet and base wafer. The annealing step may also strengthen the bond between the dielectric regions.

However, one of the challenges with this approach is that the liquid (e.g., water) dispensed on the bonding surface(s) may interact with the metal pads (e.g., copper pads), which may result in oxidation or corrosion that adversely impact the die-to-wafer bondability or electrical functionality of the interconnects if bonding is successful. Furthermore, since the metal pads are on the same surface as the containment features (e.g., SA3 features), there is a fabrication challenge since the steps required for fabrication of either set of features may not be compatible with one another, leading either to a surface that is contaminated and not suitable for hybrid bonding, or a surface with insufficient liquid confinement leading to large die-to-wafer misalignment.

The techniques discussed herein address these challenges by implementing containment features (e.g., SA3 features) on the back (i.e., non-active) side of the chiplets (e.g., IC dies) and a structural substrate such as a silicon wafer. This resolves the process compatibility issue since the subsequently formed hybrid bonding layer between the active layer of each of the chiplets and the active layer of each of the IC dies of the base wafer does not use water droplets and requires no containment features. In the techniques discussed herein, liquid is dispensed between the non-active surface of the chiplets and a structural substrate (e.g., a substrate absent passive or active IC dies). Containment features (e.g., on the non-active surface of the chiplets and the structural wafer) are used to create a reconstituted structural wafer with the chiplets bonded to it in their desired locations. Next, wafer-to-wafer bonding is used to hybrid bond the active surfaces of the chiplets to a base wafer, which also includes IC dies. The wafer-to-wafer bonded structure can then be diced into 3D die stacks for assembly and packaging using, for example, package level interconnect features on the segmented dies of the base wafer, with the interconnect features being on an opposite side of the base wafer with respect to the chiplets.

It is noted that this die-to-wafer (i.e., die-to-structural wafer) bonding offers the advantages of being fast (by allowing gross alignment pick-and-place) and accurate (with fine alignment provided by the containment features and water droplet alignment, as discussed). The subsequent hybrid bond between the active layer of each chiplet (e.g., opposite the structural wafer) and the base wafer is also highly accurate (e.g., has fine alignment) due to the chiplets having fine alignment to the structural wafer and each other, as well as the base wafer being accurately aligned to the mounted chiplets/structural wafer using fine alignment techniques that, though relatively time consuming (e.g., ~30 sec.), are time efficient at the per die level due to being performed only one-time at the wafer level (e.g., in contrast to ~500 times if done for each chiplet). The techniques discussed herein thereby resolve the discussed liquid interaction issue since now the liquid only interacts with surfaces (e.g., dielectric surfaces) that do not have any electrical interconnect functionality. Other advantages will be evident based on present disclosure.

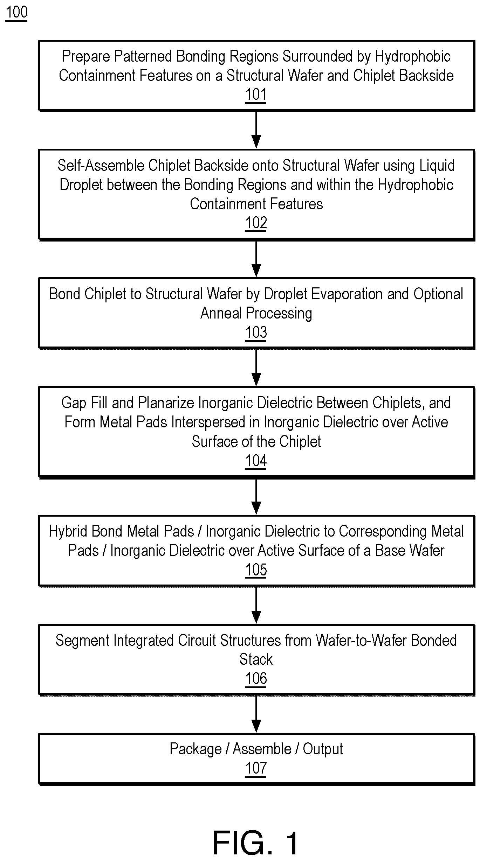

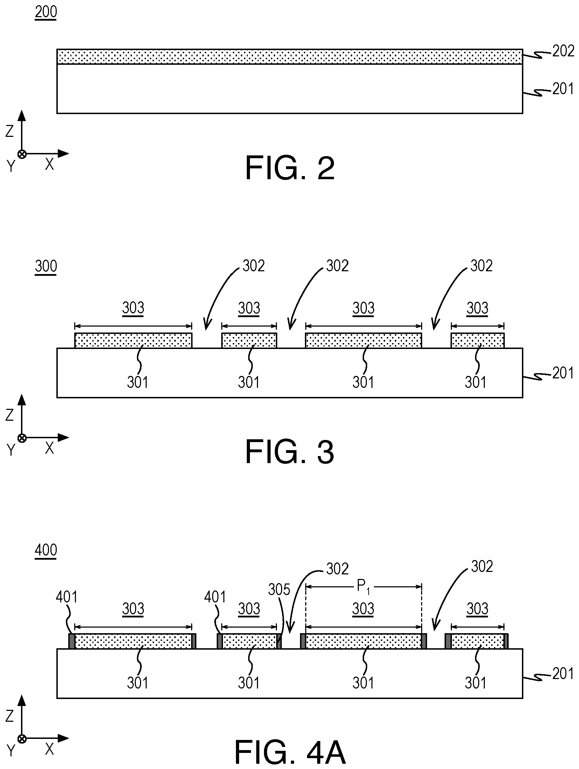

FIG. 1 provides a flow diagram illustrating an example process 100 for fabricating IC structures inclusive of 3D die stacks with backsides of IC dies being attached to a structural substrate followed the frontsides of the IC dies being hybrid bonded to a base substrate, arranged in accordance with at least some implementations of the present disclosure. For example, process 100 may be implemented to fabricate IC structure 900, assembly structure 1000, or any other structure discussed herein. In the illustrated embodiment, process 100 includes one or more operations as illustrated by operations 101-107. However, embodiments herein may include additional operations, certain operations being omitted, or operations being performed out of the order provided. FIGS. 2, 3, 4A, 4B, 4C, 4D, 4E, and 5-10 illustrate structures and components as the methods of process 100 are practiced.

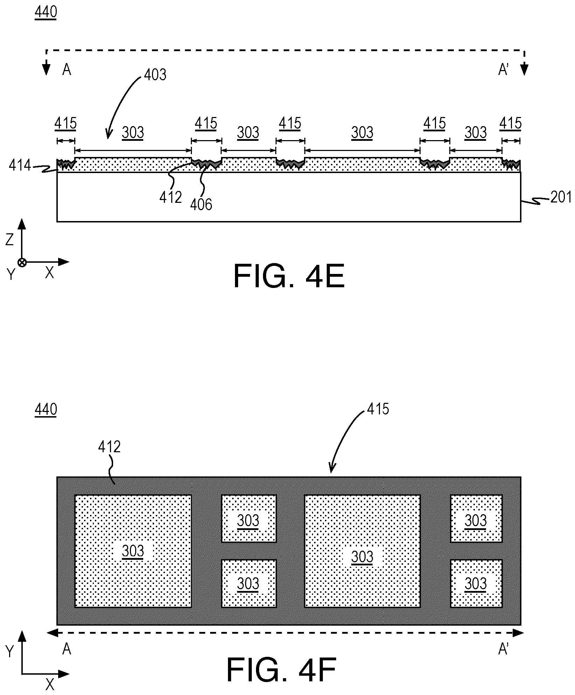

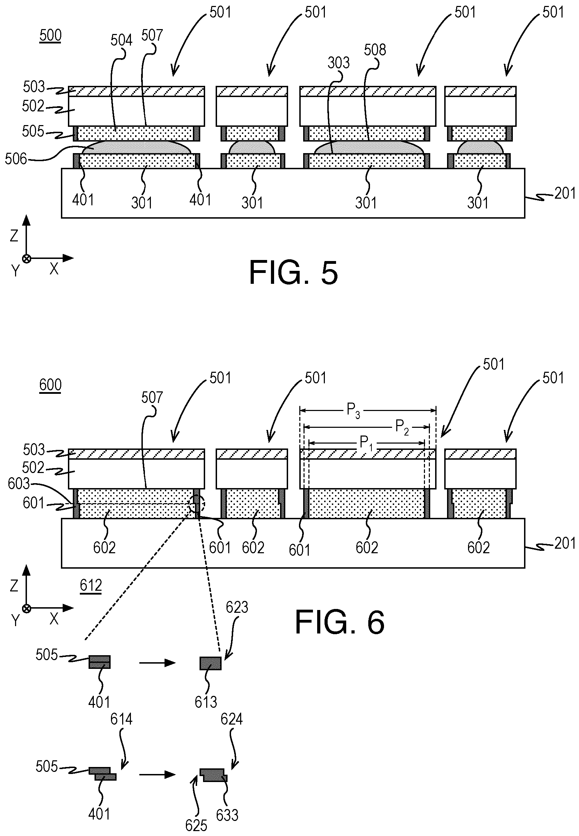

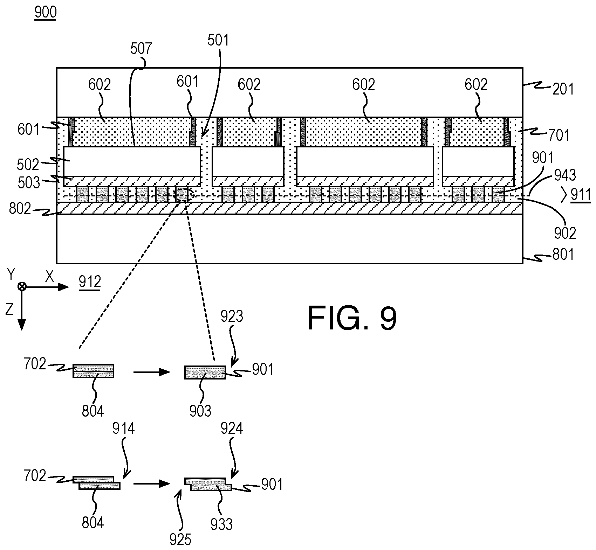

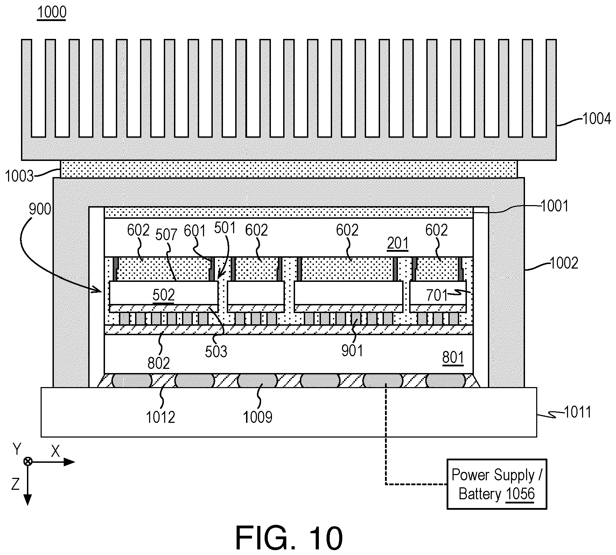

FIGS. 2, 3, 4A, 4B, 4C, 4D, and 4E are illustrations of cross-sectional side views of integrated circuit (IC) structures being prepared for self-alignment bonding, arranged in accordance with at least some implementations of the present disclosure. FIG. 4F illustrates a top-down view of the IC structure of FIG. 4E showing bonding regions defined by a hydrophobic pattern, arranged in accordance with at least some implementations of the present disclosure. FIGS. 5, 6, 7, 8, and 9 are illustrations of cross-sectional side views of IC structures during self-alignment bonding and hybrid bonding, arranged in accordance with at least some implementations of the present disclosure. FIG. 10 is an illustration of a cross-sectional side view of an assembly structure similar to the IC structure of FIG. 9 after packaging and deployment of heat removal solutions, arranged in accordance with at least some implementations of the present disclosure.

Process 100 begins at operation 101, where bonding areas surrounded by hydrophobic containment features are prepared on a structural wafer and on IC die or chiplet backsides. In process 100, IC die backsides are first attached to a structural wafer or substrate. Such attachment techniques place the IC die backsides onto the structural substrate quickly and with gross alignment and then use a liquid droplet between bonding areas of the structural wafer and the IC die to provide fine alignment using capillary forces. Such self-alignment bonding techniques allow for high throughput as high duration pick and place alignment is not needed.

FIG. 2 is an illustration of a cross-sectional side view of an IC structure 200 being prepared for self-alignment bonding. As shown, IC structure 200 includes a structural substrate 201 and a layer 202 formed on structural substrate 201. As discussed, structural substrate 201 may be a structural wafer or panel or the like and is absent any active or passive electrical features. For example, structural substrate 201 may be a monolithic material, a crystalline material, or a composite material. In some embodiments, structural substrate 201 is monocrystalline silicon such as a silicon wafer. In some embodiments, structural substrate 201 is germanium, silicon germanium, silicon carbide, or sapphire.

Layer 202 may be any suitable material for forming a bond between structural substrate 201 and an IC die. In some embodiments, the same material is formed on structural substrate 201 and the IC die for bonding. In some embodiments, layer 202 is an inorganic material. As used herein, the term inorganic material indicates materials not having carbon as a foundational component or materials not having carbon-hydrogen bonds. Typically, such materials are electrical insulators and may be characterized as inorganic dielectric material. In some embodiments, layer 202 is silicon oxide. In some embodiments, layer 202 is silicon nitride, silicon oxynitride, silicon carbonitride, or silicon carbide. In some embodiments, the out facing surface of layer 202 may be planarized to a smooth finish for subsequent bonding.

FIG. 3 illustrates an IC structure 300 similar to IC structure 200 after formation of hydrophilic structures 301 for self-aligned bonding. As discussed, hydrophilic structures 301 may be inorganic materials such as silicon oxide, silicon nitride, silicon oxynitride, silicon carbonitride, or silicon carbide. Such materials are hydrophilic such that a liquid (e.g., water) will spread out on hydrophilic structures 301 as the liquid minimizes its surface energy. Patterned hydrophilic structures 301 therefore define bonding regions 303 to which IC dies will be self-aligned, as discussed further herein below.

Hydrophilic structures 301 and openings or trenches 302 may be formed from layer 202 using any suitable technique or techniques such as patterning a resist layer on or over layer 202, etching the exposed portions of layer 202 (e.g., via dry etch), and removing the resist layer. For example, the pattern of hydrophilic structures 301, as defined by bonding regions 303, matches a desired layout of chiplets or IC dies on structural substrate 201.

FIG. 4A illustrates an IC structure 400 similar to IC structure 300 after formation of hydrophobic structures 401 adjacent hydrophilic structures 301. Hydrophobic structures 401 may be formed on sidewalls 305 of hydrophilic structures 301using any suitable technique or techniques. In some embodiments, a conformal hydrophobic material layer is formed on exposed surfaces of hydrophilic structures 301 and structural substrate 201 using, for example, spin coating or conformal vapor deposition. The conformal hydrophobic material layer is then removed from the lateral or horizontal surfaces while the conformal hydrophobic material layer remains on sidewalls 305 via an anisotropic etch such as a dry etch.

Hydrophobic structures 401, which may be characterized as hydrophobic spacers, hydrophobic materials, or the like may include any suitable hydrophobic material (e.g., material that causes a liquid water droplet to have a contact angle of greater than 90°). In some embodiments, hydrophobic structures 401 are chemical coatings or hydrophobic materials that create a hydrophobic boundary with a large contact angle (e.g., > 90°) around bonding regions 303. In some embodiments, the hydrophobic material of hydrophobic structures 401 is or includes a self-assembled monolayer (SAM) material such as an alkyl or fluoroalkyl silane (e.g., ODS, FDTS), a thiol (e.g., hexadecane thiol), a phosphonic acid (e.g., octadecyl or perfluorooctane phosphonic acid), or an alkanoic acid (e.g., heptadecanoic acid). However, non-SAM based materials or films may be used. In some embodiments, the hydrophobic material of hydrophobic structures 401 is or includes a thin polymer film such as a siloxane (e.g., PDMS and derivatives, HMDSO), a silazane (HMDS), a polyolefin (e.g., PP), or a fluorinated polymer (e.g., PTFE, PFPE, PFDA, C4F8 plasma polymerized films, etc.). Other hydrophobic materials may be used.

As discussed, hydrophobic structures 401 will contain a liquid within bonding regions 303 while hydrophilic structures 301 allow the liquid to spread out in bonding regions 303. For example, hydrophilic structures 301 may be inorganic materials such as silicon oxide, silicon nitride, silicon oxynitride, silicon carbonitride, or silicon carbide. Such materials are hydrophilic such that a liquid (e.g., water) will spread out on hydrophilic structures 301 as the liquid minimizes its surface energy. Hydrophobic structures such as hydrophobic structures 401, in contrast, will contain the liquid. Hydrophilic materials or surfaces cause a liquid droplet to have a contact angle of less than 90° (e.g., water on silicon oxide has a contact angle of ~10-20°) while a hydrophobic structure causes a contact angle of greater than 90° in the liquid droplet. As used herein, term hydrophobic structure is inclusive of both topological alterations to a material (e.g., alterations to an otherwise hydrophilic structure) and hydrophobic materials applied to a hydrophilic structure.

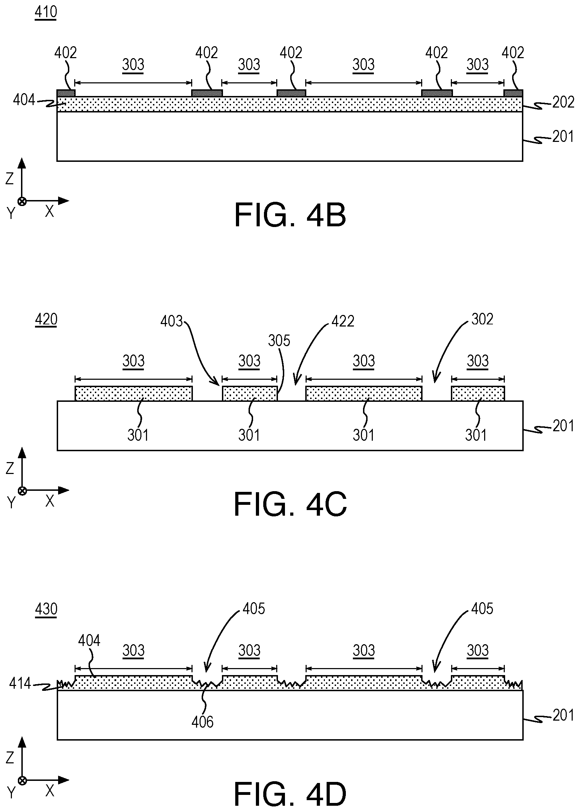

In the embodiment of FIG. 4A, bonding regions 303 are within hydrophobic structures 401 and trenches 302. Notably, trenches 302 are also hydrophobic structures, as discussed further with respect to FIG. 4C. The embodiment of FIG. 4A offers the advantages of multiple and diverse hydrophobic structures (e.g., both material based, and structure based hydrophobic structures) at the cost of increased fabrication complexity. FIGS. 4B-4E illustrate alternative hydrophilic structures and hydrophobic structures for the containment of a liquid within bonding regions 303.

FIG. 4B illustrates an IC structure 410 similar to IC structure 200 after formation of hydrophobic structures 402 to define bonding regions 303 as portions of layer 202, which is also labeled as hydrophilic structure 404. Hydrophobic structures 402 may be formed using any suitable technique or techniques such as forming a conformal hydrophobic material layer on layer 202, and subsequently patterning the conformal hydrophobic material layer by patterning a resist layer on or over the hydrophobic material layer, etching the exposed portions of the hydrophobic material layer, and removing the resist layer. For example, the pattern of hydrophobic structures 402 defines bonding regions 303, which matches a desired layout of chiplets or IC dies on structural substrate 201.

Hydrophobic structures 402 may include any hydrophobic material discussed with respect to hydrophobic structures 401. For example, hydrophobic structures 402 may be or include a self-assembled monolayer material such as an alkyl or fluoroalkyl silane, a thiol, a phosphonic acid, or an alkanoic acid, or hydrophobic structures 402 may be or include a polymer film such as a siloxane, a silazane, a polyolefin, or a fluorinated polymer. Other hydrophobic materials may be used.

As discussed, hydrophobic structures 402 will contain a liquid within bonding regions 303 while hydrophilic structure 404 allows the liquid to spread out within bonding regions 303. In the embodiment of FIG. 4B, bonding regions 303 are within hydrophobic structures 402 and on particular areas or regions of hydrophilic structure 404. Such structures offer the advantages of material based hydrophobic structures 402 with relative ease of manufacture.

FIG. 4C illustrates an IC structure 420 similar to IC structure 300 where trenches 302 are used as hydrophobic structures. As discussed, hydrophilic structures 301 cause a liquid (e.g., water) to spread out on hydrophilic structures 301 as the liquid minimizes its surface energy. Trenches 302, which may be characterized as hydrophobic structures 422, in contrast, will contain the liquid. In the context of FIG. 4C, discussed further herein below, the hydrophobic structure is trench 302 in layer 202 such that sidewalls 305 and corners 403 are defined by trenches 302. Due to trenches 302, as a liquid droplet spread out, it interacts with corner 403, which alters the surface energy characteristics of the liquid droplet and, in turn, changes the effective contact angle to greater than 90°. As illustrated with respect to FIG. 4C, in some embodiments, trenches 302 extend to a top surface of structural substrate 201. Alternatively, a bottom of trenches 302 may include a portion of layer 202. For example, any depth of trenches 302 that provides corner 403 may be deployed.

FIG. 4D illustrates an IC structure 430 similar to IC structure 200 after formation of hydrophobic structures 405 including roughened surfaces 406 for self-aligned bonding. Hydrophobic structures 405 may be formed using any suitable technique or techniques such as surface texturing techniques inclusive of laser surface roughening. Roughened surfaces 406 may have any suitable surface roughness relative to the surface of hydrophilic structure 404 in bonding regions 303. In some embodiments, the surface roughness (i.e., measured as the deviations in the direction of the normal vector of a real surface from its ideal form) of roughened surfaces 406 is not less than twice the surface roughness of the surface of hydrophilic structure 404 in bonding regions 303. For example, a ratio of the roughnesses may be defined as the surface roughness of roughened surfaces 406 divided by the surface roughness of the surface of hydrophilic structure 404 in bonding regions 303. In some embodiments, the ratio is not less than two. In some embodiments, the ratio is not less than five, ten, or twenty. In some embodiments, the ratio is not less than 100. Other surface roughness ratios may be used.

As discussed, hydrophobic structures 405 will contain a liquid within bonding regions 303 while modified layer 414 allows the liquid to spread out within bonding regions 303. In the embodiment of FIG. 4D, bonding regions 303 of modified layer 414 are contained between roughened surfaces 406. As discussed, bonding regions 303 are on particular areas or regions of modified layer 414 where IC dies or chiplets are to be aligned.

FIG. 4E illustrates an IC structure 440 similar to IC structure 430 after formation of hydrophobic structures 412 to provide containment within bonding regions 303. Hydrophobic structures 412 may be formed using any suitable technique or techniques such as forming a conformal hydrophobic material layer on modified layer 414, and subsequently patterning the conformal hydrophobic material layer by patterning a resist layer on or over the hydrophobic material layer, etching the exposed portions of the hydrophobic material layer, and removing the resist layer. Hydrophobic structures 412 may include any hydrophobic material discussed herein such as a self-assembled monolayer material including an alkyl or fluoroalkyl silane, a thiol, a phosphonic acid, or an alkanoic acid, or a polymer film including a siloxane, a silazane, a polyolefin, or a fluorinated polymer. Other hydrophobic materials may be used. In accordance with some embodiments of the present disclosure, structures 412 may include a layer of material having an atomic composition of at least 10% carbon, a layer of material having an atomic composition of at least 10% fluorine, a layer of material having an atomic composition of at least 10% phosphorus, a layer of material having an atomic composition of at least 10% sulfur, and/or or a layer of material having an atomic composition of at least 10% silicon.

Hydrophobic structures 412 further aid, along with roughened surfaces 406, in the containment of a liquid within bonding regions 303 while bonding regions 303 allow the liquid to spread out. As shown in FIG. 4E, any of the previously discussed hydrophobic structures defines keep out regions or a hydrophobic pattern 415 that fully or nearly fully surrounds each of bonding regions 303 with hydrophobic structures.

FIG. 4F illustrates a top-down view of IC structure 440 showing bonding regions 303 defined by hydrophobic pattern 415. In the example of FIG. 4F, hydrophobic structures 412 and hydrophobic structures 405 provide containment within bonding regions 303 (with only hydrophobic structures 412 being visible in the top-down view). However, any of hydrophobic structures 401, 402, 422, 405 may provide the same hydrophobic pattern 415. As shown, bonding regions 303 may be the same or different sizes and bonding regions 303 define a chiplet or IC die layout on structural substrate 201, which underlies hydrophobic pattern 415 and bonding regions 303. In the following, an IC die or chiplet is first gross aligned to each of bonding regions 303. This gross alignment may be performed by pick and place equipment and may be within, for example, 25-50 µm. A liquid droplet (e.g., water droplet) between each of bonding regions 303 and the corresponding IC die or chiplet then, via capillary forces, provides fine alignment (in a self-aligned manner) of the IC die or chiplet within each of bonding regions 303. This fine alignment may be to within, for example, 200 nm or less.

Notably, each IC die or chiplet also includes a bonding region surrounded by a hydrophobic structure or structures on the backside of each IC die or chiplet. These bonding regions and hydrophobic structures may include any characteristics discussed herein and may be formed using the same or similar techniques. In some embodiments, the bonding regions and hydrophobic structures are fabricated, as discussed above, on a backside of a wafer including the IC dies or chiplets. The IC dies or chiplets are then segmented (i.e., diced) from the wafer such that each of the IC dies or chiplets includes a single bonding region surrounded by one or more hydrophobic structures.

Returning to FIG. 1, process 100 continues at operation 102, where an IC die or chiplet backside is self-assembled onto a structural wafer using a liquid droplet between bonding regions and within the hydrophobic containment features prepared at operation 101. In some embodiments, the water droplet is applied to a hydrophilic bonding region of a structural substrate. In some embodiments, the water droplet is applied to a hydrophilic bonding region of an IC die backside. In either event, the IC die backside is placed on or over the hydrophilic bonding region of the structural substrate (using gross alignment) and the interplay of the droplet, the hydrophilic bonding region, and the hydrophobic containment features cause the IC die to self-align with high accuracy to the structural substrate.

FIG. 5 is an illustration of a cross-sectional side view of an IC structure 500 during self-alignment bonding. As shown, IC structure 500 includes hydrophilic structures 301 on or over structural substrate 201 and hydrophobic structures 401 adjacent hydrophilic structures 301 and also on or over structural substrate 201. Although illustrated with respect to hydrophilic structures 301 and hydrophobic structures 401, any hydrophilic structures 301 and hydrophobic structures discussed herein may be deployed in the IC structures of FIGS. 5-10.

As shown in FIG. 5, each of IC dies 501 includes a substrate 502, an active layer 503, and a backside surface 507. Active layer 503 (or an active surface) includes a device layer and/or an interconnect layer. For example, the device layer may include transistors, capacitors, or other IC devices. The interconnect layer may be over the device layer and may include metallization levels that interconnect the devices of the device layer and provide routing to outside devices. Substrate 502 may include any suitable material or materials such as a semiconductor material such as monocrystalline silicon (Si), germanium (Ge), silicon germanium (SiGe), III-V materials (e.g., gallium arsenide (GaAs)), silicon carbide (SiC), sapphire (Al₂O₃), or any combination thereof. Backside surface 507 is opposite active layer 503 and may be characterized as a non-active surface.

On or over each of IC dies 501, hydrophilic structures 504 (analogous to hydrophilic structures 301) and hydrophobic structures 505 (analogous to hydrophobic structures 401) are formed as discussed herein above. Although illustrated with respect to hydrophilic structures 504 being analogous to hydrophilic structures 301 and hydrophobic structures 505 being analogous to hydrophobic structures 401, hydrophilic structures 504 may deploy any hydrophilic structures and hydrophobic structures 505 may deploy any hydrophobic structures discussed above. Hydrophilic structures 504 may be any materials, and have any characteristics discussed herein. Similarly, hydrophobic structures 505 may be any materials, and have any characteristics discussed herein. Notably, the structures discussed with respect to FIGS. 2, 3, and 4A-4F may be formed with respect to hydrophilic structures 504 and hydrophobic structures 505 without limitation.

The combination of hydrophilic structures/hydrophobic structures on structural substrate 201 and the combination of hydrophilic structures/hydrophobic structures on IC dies 501 may be the same (as shown) or they may be different. Notably, the hydrophilic structures/hydrophobic structures illustrated with respect to FIG. 4B may only be compatible with other hydrophilic structures/hydrophobic structures (i.e., any but those of FIG. 4B) since bonding regions 303, 508 surrounded by hydrophobic structures of FIG. 4B would not be in contact if used on both structural substrate 201 and any of IC dies 501.

As shown, liquid droplets 506 are placed on bonding regions 303 of hydrophilic structures 301 (or on bonding regions 508 of hydrophilic structures 504). Liquid droplets 506 may be any suitable liquid such as water of any suitable volume. And bonding regions 303 and bonding regions 508 are brought together using, for example, pick and place of IC dies 501. As shown, liquid droplets 506 spread out on bonding regions 303 (or bonding regions 508) and are contained by hydrophobic structures 401 (or hydrophobic structures 505). IC dies 501 are grossly and advantageously quickly aligned to bonding regions 303 and liquid droplets 506, confined by the self-alignment assisting features discussed herein, quickly fine align each of IC dies 501 to the corresponding bonding region 303.

Returning to FIG. 1, process 100 continues at operation 103, where the IC dies or chiplets are bonded to the structural wafer by evaporating the liquid droplets and optional anneal processing. For example, the liquid droplet applied at operation 102 evaporates relatively quickly after alignment and the inorganic materials hold the IC dies or chiplets in place due to, for example, Van der Waals forces. A subsequent anneal operation may be performed to bond the IC dies or chiplets to the bonding regions of the structural wafer by melding the inorganic materials therebetween.

FIG. 6 is an illustration of a cross-sectional side view of an IC structure 600 similar to IC structure 500 after liquid droplets 506 evaporate and after bonding to form an inorganic layer 602 between each of IC dies 501 and structural substrate 201. As shown, IC structure 600 includes structural substrate 201 coupled to backside surface 507 of each IC die 501 by inorganic layer 602, which is on backside surface 507 and on a top surface of structural substrate 201. For example, a bond may be formed across a bond plane 603. Notably, inorganic layer 602 is formed by combining hydrophilic structures 301, 504. Inorganic layer 602 may be characterized as an inorganic material, an inorganic bond layer, an inorganic bonding material, or the like.

Furthermore, each of inorganic layers 602 are surrounded (entirely or mostly) by hydrophobic structures 601. In the context of FIG. 6, hydrophobic structures 601 are formed of hydrophobic structures 401, 505, though the materials of hydrophobic structures 401, 505 may not combine or meld. As shown in FIG. 6, hydrophobic structure 601 extends around a perimeter P1 of inorganic layer 602 (refer to FIG. 4F). As used herein, the term perimeter is used in its ordinary meaning to indicate an outer boundary of hydrophobic structure 601 in the x-y plane. For perimeters that are not taken in the same plane, such perimeters are projected into the same plane for determination of their dimensions. Furthermore, an outer perimeter P2 of hydrophobic structure 601 is fully within an outer perimeter P3 of IC die 501. It is noted that a single continuous hydrophobic structure 601 may surround inorganic layer 602 or multiple discontinuous hydrophobic structures 601 may surround inorganic layer 602.

As shown in insert 612, in some embodiments, adjacent hydrophobic structures 401, 505 form a composite hydrophobic structure 613 (e.g., any of hydrophobic structures 601) that has substantially aligned sidewalls 623. However, in other embodiments, adjacent hydrophobic structures 401, 505 have a misalignment 614 during anneal and form a composite hydrophobic structure 633 (e.g., any of hydrophobic structures 601) that has a substantially misaligned sidewall 624 and therefore hydrophobic structure 633 includes a jut or overhang 625. For example, the sidewall of hydrophobic structure 633 may have substantially vertical sidewall portions and a substantially horizontal sidewall portion. In some embodiments, hydrophobic structure 601 extends from backside surface 507 to structural substrate 201 (i.e., in the illustrated example and the example of FIG. 4A).

Returning to FIG. 1, process 100 continues at operation 104, where metal pads interspersed in inorganic dielectric material are formed over the active surface of the chiplets. Such inorganic dielectric material and metal pads may be formed using any suitable technique or techniques. In some embodiments, the inorganic dielectric material is formed over the active surface of the IC dies chiplets (e.g., on or over the device layer and interconnect layers) and the metal pads are formed in the inorganic dielectric material using damascene or dual damascene techniques. A single layer of metal pads may be formed in inorganic dielectric material or multiple layers of inorganic dielectric material/metal vias, routing, pads may be fabricated as is known in the art. In some embodiments, the inorganic dielectric material is deposited and the metal pads are formed after bonding the chiplets (as illustrated herein). Such techniques offer advantages in terms of alignment. However, in some embodiments, the inorganic dielectric material and metal pads may be formed prior to chiplet bonding.

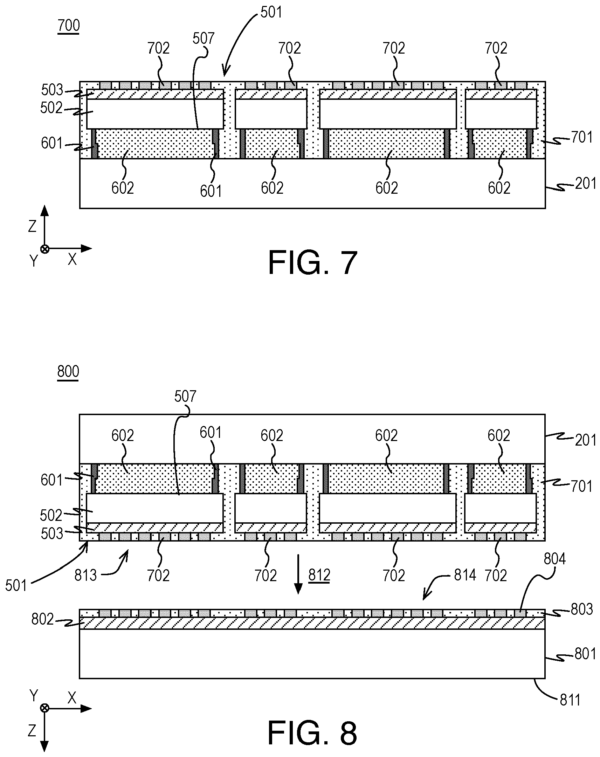

FIG. 7 is an illustration of a cross-sectional side view of IC structure 700 similar to IC structure 600 after forming inorganic dielectric 701 and metal pads 702. As shown, inorganic dielectric 701 may be deposited as a fill material using any suitable technique or techniques such as vapor deposition techniques followed by planarization. Metal pads 702 are then formed using any suitable technique or techniques such as single or dual damascene techniques. Inorganic dielectric 701 may be any material suitable for hybrid bonding such as silicon oxide, silicon nitride, silicon oxynitride, silicon carbonitride, silicon carbide, or combinations thereof (e.g., a layer of one of those materials covered by a second layer of another one of those materials). Metal pads 702 may be any suitable metal such as copper. In some embodiments, metal pads 702 are recessed (i.e., in the z-dimension) relative to the top surface of inorganic dielectric 701. Furthermore, inorganic dielectric 701 may be planarized to a smooth finish to promote bonding.

Returning to FIG. 1, process 100 continues at operation 105, where hybrid bonding is performed to direct bond the metal pads and inorganic dielectric surface formed over the active side of the IC dies at operation 104 to corresponding metal pads and inorganic dielectric surface formed over a base wafer. In contrast to the discussed structural wafer, the base wafer includes an interconnect layer, optional device layer, and routing through base wafer for connection to an outside package or board. The hybrid or direct bonding of operation 105 may be performed using any suitable technique or techniques. In some embodiments, the substrates (i.e., wafers) are aligned using fine alignment. As discussed, this is done only once at the wafer level and is thus time efficient at the per die level.

In some embodiments, after alignment, the wafers are brought into contact and the inorganic dielectrics bond, even at room temperature. Optional compression may be provided while bringing the wafers into contact. When brought into close contact, the aligned dielectric materials first bond at room temperature due to, for example, Van der Waals forces therebetween. A subsequent anneal or thermal process is performed to bond the metallization structures due to inter-diffusion of the metals to form a composite or bonded metal structure. Such direct bonding advantageously offers a strong bond with a small z-height.

FIG. 8 illustrates an IC structure 800 similar to IC structure 700 as hybrid bonding is being performed to direct bond IC die active layers to an active layer of a base substrate 801. As shown, base substrate 801 includes an active layer 802. Active layer 802 (or an active surface) includes a device layer and/or an interconnect layer. For example, a device layer may include transistors, capacitors, or other IC devices. An interconnect layer may be over the device layer and may include metallization levels that interconnect the devices of the device layer and provide routing to outside devices. In some embodiments, base substrate 801 includes active devices in active layer 802 and routing from active layer 802 to backside surface 811. In some embodiments, base substrate 801 includes routing from active layer 802 to backside surface 811, and is absent active devices. Base substrate 801 may include any suitable material or materials such as a semiconductor material such as monocrystalline silicon (Si), germanium (Ge), silicon germanium (SiGe), III-V materials (e.g., gallium arsenide (GaAs)), silicon carbide (SiC), sapphire (Al₂O₃), or any combination thereof.

Metal pads 804 interspersed in inorganic dielectric 803 are formed over active layer 802 and have a layout corresponding to metal pads 702. As shown, a hybrid bonding operation 812 may first bring surface 813 into contact with surface 814 to bond inorganic dielectric 701 and inorganic dielectric 803. An anneal operation is then provided to bond metal pads 804 and metal pads 702 as well as to improve the bond between inorganic dielectric 701 and inorganic dielectric 803.

FIG. 9 illustrates an IC structure 900 similar to IC structure 800 after hybrid bonding is completed. As shown, the discussed hybrid bonding forms composite metal structures 901 and a composite dielectric portion 902 across a bonding plane 943. Thereby a hybrid bond 911 between IC dies 501 and base substrate 801 is formed. As shown in insert 912, in some embodiments, adjacent metal pads are annealed to form a composite metal structure 903 (one of composite metal structures 901) such that metal structure 903 has a substantially aligned sidewalls 923. However, in other embodiments, adjacent metal pads have a misalignment 914 during anneal and form a composite metal structure 933 such that metal structure 933 has a substantially misaligned sidewalls and therefore metal structure 933 includes a jut 924 and an overhang 925. For example, the sidewall of metal structure 933 may have substantially vertical sidewall portions and a substantially horizontal sidewall portion (e.g., at jut 924 and overhang 925).

As shown, IC structure 900 includes base substrate 801 having an active layer 802, which may include a device layer, an interconnect layer or both. IC structure 900 further includes IC dies 501 each having active layer 503, which may include a device layer and an interconnect layer, and backside surface 507 opposite active layer 503. Each active layer 503 is coupled to active layer 802 by hybrid bond 911 therebetween. Hybrid bond 911 includes composite metal structures 901 and composite dielectric portion 902. The term composite metal structure indicates a metal structure or metallization that is made up of two or more metal sub-structures or metallizations.

Returning to FIG. 1, process 100 continues at operation 106, where the integrated circuit structure is segmented (or diced) from the wafer-to-wafer bonded stack. For example, IC structure 900 may be segmented from a wafer using known dicing techniques. Process 100 continues at operation 107, where the resultant device (e.g., IC structure) may be packaged, assembled, implemented in any suitable form factor device such as a laptop, a netbook, a notebook, an ultrabook, a smartphone, a tablet, a personal digital assistant, an ultra-mobile PC, a mobile phone, a desktop computer, a server, a printer, a scanner, a monitor, a set-top box, an entertainment control unit, a digital camera, a portable music player, a digital video recorder, or the like.

FIG. 10 illustrates an example microelectronic device assembly 1000 including a 3D die stack including a die backside bonded to a structural substrate using hydrophobic containment features and frontside hybrid bonded to a base substrate, in accordance with some embodiments. As shown, IC structure 900 is incorporated into microelectronic device assembly 1000. Although illustrated with respect to the hydrophobic structures of FIG. 4A, IC structure 900 and, in turn microelectronic device assembly 1000, may include any hydrophobic structures discussed herein. Microelectronic device assembly 1000 may include any number of IC structures 900 mounted to a substrate 1011 via interconnects 1009, which are optionally embedded in a mold or underfill material 1012. Substrate 1011 may be a package substrate, interposer, or board (such as a motherboard). Any number of IC structures 900 having the same or different hydrophobic structures may be attached to substrate 1011.

Microelectronic device assembly 1000 further includes a power supply 1056 coupled to one or more of substrate 1011 (i.e., a board, package substrate, or interposer), IC dies 501, and/or other components of microelectronic device assembly 1000. Power supply 1056 may include a battery, voltage converter, power supply circuitry, or the like. Microelectronic device assembly 1000 further includes a thermal interface material (TIM) 1001 disposed on a top surface of structural substrate 201. TIM 1001 may include any suitable thermal interface material and may be characterized as TIM 1. Integrated heat spreader 1002 having a surface on TIM 1001 extends over IC structure 900 and is mounted to substrate 1011. Microelectronic device assembly 1000 further includes a TIM 1003 disposed on a top surface of integrated heat spreader 1002. TIM 1003 may include any suitable thermal interface material and may be characterized as TIM 2. TIM 1001 and TIM 1003 may be the same materials, or they may be different. A heat sink 1004 (e.g., an exemplary heat dissipation device or thermal solution) is on TIM 1003 and dissipates heat. Microelectronic device assembly 1000 may be used in desktop and server form factors. In other contexts, a heat solution such as a heat pipe or heat spreader may be mounted directly on TIM 1001. Such assemblies may be used in smaller form factor devices. Other heat dissipation devices may be used.

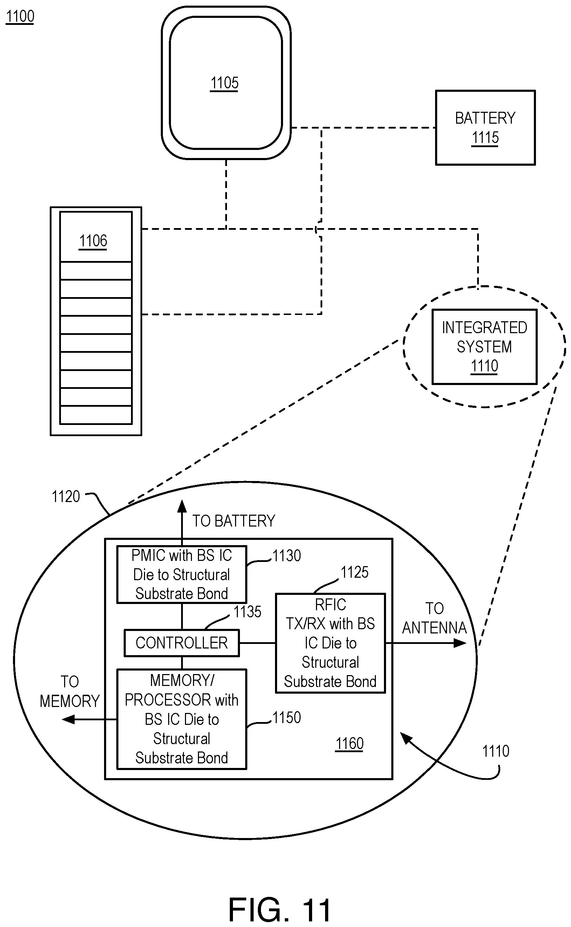

FIG. 11 illustrates exemplary systems 1100 deploying a 3D die stack including a die backside bonded to a structural substrate using hydrophobic containment features and frontside hybrid bonded to a base substrate, in accordance with some embodiments. The system may be a mobile computing platform 1105 and/or a data server machine 1106, for example. Either may employ a component assembly including an IC structure as described herein. Server machine 1106 may be any commercial server, for example, including any number of high-performance computing platforms disposed within a rack and networked together for electronic data processing, which in the exemplary embodiment includes an integrated circuit (IC) die assembly 1150 with a 3D die stack including a die backside bonded to a structural substrate using hydrophobic containment features and frontside hybrid bonded to a base substrate as described elsewhere herein. Mobile computing platform 1105 may be any portable device configured for each of electronic data display, electronic data processing, wireless electronic data transmission, or the like. For example, mobile computing platform 1105 may be any of a tablet, a smart phone, a laptop computer, etc., and may include a display screen (e.g., a capacitive, inductive, resistive, or optical touchscreen), a chip-level or package-level integrated system 1110, and a battery 1115. Although illustrated with respect to mobile computing platform 1105, in other examples, chip-level or package-level integrated system 1110 and a battery 1115 may be implemented in a desktop computing platform, an automotive computing platform, an internet of things platform, or the like. As discussed below, in some examples, the disclosed systems may include a sub-system 1160 such as a system on a chip (SOC) or an integrated system of multiple ICs, which is illustrated with respect to mobile computing platform 1105.

Whether disposed within integrated system 1110 illustrated in expanded view 1120 or as a stand-alone packaged device within data server machine 1106, sub-system 1160 may include memory circuitry and/or processor circuitry 1150 (e.g., RAM, a microprocessor, a multi-core microprocessor, graphics processor, etc.), a power management integrated circuit (PMIC) 1130, a controller 1135, and a radio frequency integrated circuit (RFIC) 1125 (e.g., including a wideband RF transmitter and/or receiver (TX/RX)). As shown, one or more IC dice, such as memory circuitry and/or processor circuitry 1150 may be packaged, assembled and implemented, such that the package has one or more 3D die stack including a die backside bonded to a structural substrate using hydrophobic containment features and frontside hybrid bonded to a base substrate as described herein. In some embodiments, RFIC 1125 includes a digital baseband and an analog front end module further comprising a power amplifier on a transmit path and a low noise amplifier on a receive path). Functionally, PMIC 1130 may perform battery power regulation, DC-to-DC conversion, etc., and so has an input coupled to battery 1115, and an output providing a current supply to other functional modules. As further illustrated in FIG. 11, in the exemplary embodiment, RFIC 1125 has an output coupled to an antenna (not shown) to implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. Memory circuitry and/or processor circuitry 1150 may provide memory functionality, high level control, data processing and the like for sub-system 1160. In alternative implementations, each of the SOC modules may be integrated onto separate ICs coupled to a package substrate, interposer, or board.

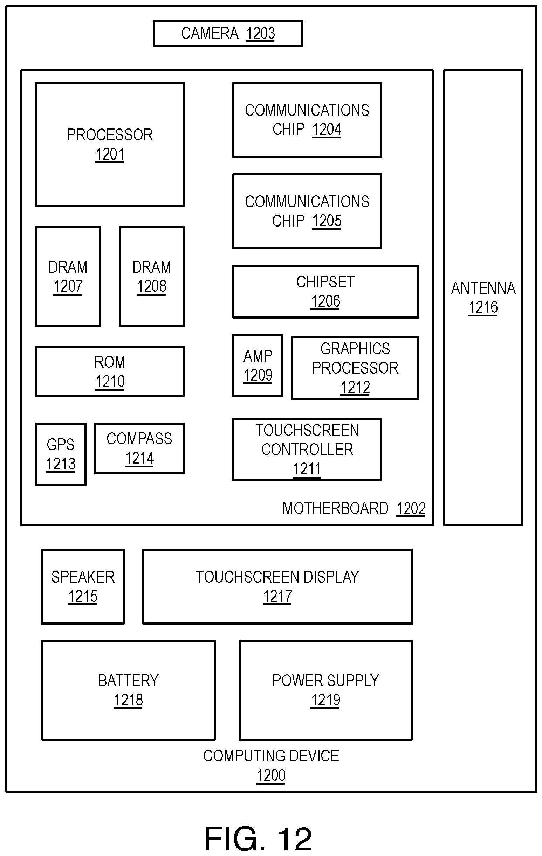

FIG. 12 is a functional block diagram of an electronic computing device 1200, in accordance with some embodiments. For example, device 1200 may, via any suitable component therein, employ a 3D die stack including a die backside bonded to a structural substrate using hydrophobic containment features and frontside hybrid bonded to a base substrate in accordance with any embodiments described elsewhere herein. Device 1200 further includes a motherboard or package substrate 1202 hosting a number of components, such as, but not limited to, a processor 1201 (e.g., an applications processor). Processor 1201 may be physically and/or electrically coupled to package substrate 1202. In some examples, processor 1201 is within a packaged IC assembly that includes a 3D die stack including a die backside bonded to a structural substrate using hydrophobic containment features and frontside hybrid bonded to a base substrate as described elsewhere herein. In general, the term "processor" or "microprocessor" may refer to any device or portion of a device that processes electronic data from registers and/or memory to transform that electronic data into other electronic data that may be further stored in registers and/or memory.

In various examples, one or more communication chips 1204, 1205 may also be physically and/or electrically coupled to the package substrate 1202. In further implementations, communication chips 1204, 1205 may be part of processor 1201. Depending on its applications, computing device 1200 may include other components that may or may not be physically and electrically coupled to package substrate 1202. These other components include, but are not limited to, volatile memory (e.g., DRAM 1207, 1208), non-volatile memory (e.g., ROM 1210), flash memory (e.g., NAND or NOR), magnetic memory, a graphics processor 1212, a digital signal processor, a crypto processor, a chipset 1206, an antenna 1216, touchscreen display 1217, touchscreen controller 1211, battery 1218, a power supply 1219, audio codec, video codec, power amplifier 1209, global positioning system (GPS) device 1213, compass 1214, accelerometer, gyroscope, speaker 1215, camera 1203, and mass storage device (such as hard disk drive, solid-state drive (SSD), compact disk (CD), digital versatile disk (DVD), and so forth, or the like.

Communication chips 1204, 1205 may enable wireless communications for the transfer of data to and from the computing device 1200. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. Communication chips 1204, 1205 may implement any of a number of wireless standards or protocols, including, but not limited to, those described elsewhere herein. As discussed, computing device 1200 may include a plurality of communication chips 1204, 1205. For example, a first communication chip may be dedicated to shorter-range wireless communications, such as Wi-Fi and Bluetooth, and a second communication chip may be dedicated to longer-range wireless communications such as GPS, EDGE, GPRS, CDMA, WiMAX, LTE, Ev-DO, and others.

While certain features set forth herein have been described with reference to various implementations, this description is not intended to be construed in a limiting sense. Hence, various modifications of the implementations described herein, as well as other implementations, which are apparent to persons skilled in the art to which the present disclosure pertains are deemed to lie within the spirit and scope of the present disclosure.

It will be recognized that the invention is not limited to the embodiments so described, but can be practiced with modification and alteration without departing from the scope of the appended claims. For example, the above embodiments may include specific combinations of features as further provided below.

The following pertain to exemplary embodiments.

In one or more first embodiments, an apparatus comprises a first substrate comprising a first interconnect layer, an integrated circuit (IC) die comprising a second interconnect layer and a backside surface opposite the second interconnect layer, wherein the second interconnect layer of the IC die is coupled to the first interconnect layer of the first substrate by composite metal structures therebetween, a second substrate coupled to the backside surface of the IC die by an inorganic layer on the backside surface of the IC die and the second substrate, and one or more hydrophobic structures extending around an outer perimeter of the inorganic layer.

In one or more second embodiments, further to the first embodiments, the outer perimeter of the inorganic layer is fully within an outer perimeter of the IC die.

In one or more third embodiments, further to the first or second embodiments, an outer perimeter of the one or more hydrophobic structures is fully within the outer perimeter of the IC die.

In one or more fourth embodiments, further to the first through third embodiments, a second inorganic material is in direct contact with the hydrophobic structures.

In one or more fifth embodiments, further to the first through fourth embodiments, the one or more hydrophobic structures comprise a hydrophobic material, the hydrophobic material comprising one of a self-assembled monolayer material or a polymer film.

In one or more sixth embodiments, further to the first through fifth embodiments, the hydrophobic material extends from the backside surface of the IC die to the second substrate.

In one or more seventh embodiments, further to the first through sixth embodiments, the one or more hydrophobic structures comprises a roughened surface of the inorganic layer or a trench in the inorganic layer.

In one or more eighth embodiments, further to the first through seventh embodiments, the one or more hydrophobic structures comprise a first hydrophobic material portion on the backside surface of the IC die and a second hydrophobic material portion on the second substrate, wherein the first and second hydrophobic material portions have misaligned sidewalls.

In one or more ninth embodiments, further to the first through eighth embodiments, the first substrate comprises one of an active IC die, a passive IC die, or an interposer, and the second substrate comprises a monolithic material.

In one or more tenth embodiments, further to the first through ninth embodiments, the composite metal structures comprise a portion of a hybrid bond between the second interconnect layer of the IC and the first interconnect layer of the first substrate, the hybrid bond further comprising a second inorganic layer between the second interconnect layer of the IC die and the first interconnect layer of the first substrate.

In one or more eleventh embodiments, a system comprises an integrated circuit (IC) structure according to any of the apparatuses of the first through tenth embodiments, and a power supply or display coupled to the IC structure.

In one or more twelfth embodiments, a system comprises a power supply and an IC structure coupled to the power supply, the IC structure comprising a base substrate comprising a first active layer, an IC die comprising a second active layer and a backside surface opposite the second active layer, wherein the second active layer of the IC die is coupled to the first active layer of the base substrate by a hybrid bond therebetween, a structural substrate coupled to the backside surface of the IC die by an inorganic material on the backside surface of the IC die and the structural substrate, and one or more hydrophobic structures extending around an outer perimeter of the inorganic material.

In one or more thirteenth embodiments, further to the twelfth embodiments, the outer perimeter of the inorganic material is fully within an outer perimeter of the IC die, and wherein a second inorganic material is in direct contact with the hydrophobic structures.

In one or more fourteenth embodiments, further to the twelfth or thirteenth embodiments, the one or more hydrophobic structures comprise a hydrophobic material, the hydrophobic material comprising one of a self-assembled monolayer material or a polymer film, or the one or more hydrophobic structures comprise a roughened surface of the inorganic material or a trench in the inorganic material.

In one or more fifteenth embodiments, further to the twelfth through fourteenth embodiments, the one or more hydrophobic structures comprise a first hydrophobic material portion on the backside surface of the IC die and a second hydrophobic material portion on the structural substrate, wherein the first and second hydrophobic material portions have misaligned sidewalls.

In one or more sixteenth embodiments, further to the twelfth through fifteenth embodiments, the system further comprises a heat dissipation device thermally coupled to the structural substrate opposite the second die IC.

In one or more seventeenth embodiments, a method comprises evaporating a liquid droplet between a first bonding region of a structural substrate, the first bonding region surrounded by first hydrophobic structures, and a second bonding region of an integrated circuit (IC) die, the second bonding region surrounded by second hydrophobic structures and over a backside surface of the IC die, to bond the first and second bonding regions, forming a plurality of first metal pads over an interconnect layer of the IC die, the first metal pads interspersed in a first inorganic dielectric material, and hybrid bonding the first metal pads and first inorganic dielectric material to second metal pads and second inorganic dielectric material of a base substrate.

In one or more eighteenth embodiments, further to the seventeenth embodiments, bonding the first and second bonding regions comprises annealing the first and second bonding regions.

In one or more nineteenth embodiments, further to the seventeenth or eighteenth embodiments, forming the plurality of first metal pads over the interconnect layer of the IC die comprises forming the first inorganic dielectric material over the bonded IC die and forming the first metal pads within the first inorganic dielectric material.

In one or more twentieth embodiments, further to the seventeenth through nineteenth embodiments, said hybrid bonding comprises a wafer-to-wafer bonding of the base substrate to the structural substrate, the method further comprising dicing an IC structure from the bonded wafers.

In one or more twenty-first embodiments, further to the seventeenth through twentieth embodiments, the first hydrophobic structures comprise a hydrophobic material, the hydrophobic material comprising one of a self-assembled monolayer material or a polymer film, or the first hydrophobic structures comprise a roughened surface of an inorganic layer or a trench in the inorganic layer.

In one or more twenty-second embodiments, an apparatus comprises a first substrate comprising a first interconnect layer, an integrated circuit (IC) die comprising a second interconnect layer and a backside surface opposite the second interconnect layer, wherein the second interconnect layer of the IC die is coupled to the first interconnect layer of the first substrate by composite metal structures therebetween, a second substrate coupled to the backside surface of the IC die by an inorganic layer on the backside surface of the IC die and the second substrate, and one or more structures extending around an outer perimeter of the inorganic layer, wherein the one or more structures comprise a layer of material having an atomic composition of at least ten percent carbon or at least ten percent fluorine.

In one or more twenty-third embodiments, further to the twenty-second embodiments, the layer of material comprises a layer of hydrophobic material.

In one or more twenty-fourth embodiments, further to the twenty-second or second embodiments, the layer of material extends from the backside surface of the IC die to the second substrate.

In one or more twenty-fifth embodiments, further to the twenty-second through third embodiments, the outer perimeter of the inorganic layer is fully within an outer perimeter of the IC die.

In one or more twenty-sixth embodiments, further to the twenty-second through fourth embodiments, an outer perimeter of the one or more structures is fully within the outer perimeter of the IC die.

It will be recognized that the invention is not limited to the embodiments so described, but can be practiced with modification and alteration without departing from the scope of the appended claims. For example, the above embodiments may include specific combination of features. However, the above embodiments are not limited in this regard and, in various implementations, the above embodiments may include undertaking only a subset of such features, undertaking a different order of such features, undertaking a different combination of such features, and/or undertaking additional features than those features explicitly listed. The scope of the invention should, therefore, be determined with reference to the appended claims, along with the full scope of equivalents to which such claims are entitled.

## Claims

1. An apparatus, comprising:
a first substrate comprising a first interconnect layer;
an integrated circuit (IC) die comprising a second interconnect layer and a backside surface opposite the second interconnect layer, wherein the second interconnect layer of the IC die is coupled to the first interconnect layer of the first substrate by composite metal structures therebetween;
a second substrate coupled to the backside surface of the IC die by an inorganic layer on the backside surface of the IC die and the second substrate; and
one or more hydrophobic structures extending around an outer perimeter of the inorganic layer.

2. The apparatus of claim 1, wherein the outer perimeter of the inorganic layer is fully within an outer perimeter of the IC die.

3. The apparatus of claim 2, wherein an outer perimeter of the one or more hydrophobic structures is fully within the outer perimeter of the IC die.

4. The apparatus of any of claims 1 to 3, wherein a second inorganic material is in direct contact with the hydrophobic structures.

5. The apparatus of any of claims 1 to 4, wherein the one or more hydrophobic structures comprise a hydrophobic material, the hydrophobic material comprising one of a self-assembled monolayer material or a polymer film.

6. The apparatus of claim 5, wherein the hydrophobic material extends from the backside surface of the IC die to the second substrate.

7. The apparatus of any of claims 1 to 5, wherein the one or more hydrophobic structures comprises a roughened surface of the inorganic layer or a trench in the inorganic layer.

8. The apparatus of any of claims 1 to 4, wherein the one or more hydrophobic structures comprise a first hydrophobic material portion on the backside surface of the IC die and a second hydrophobic material portion on the second substrate, wherein the first and second hydrophobic material portions have misaligned sidewalls.

9. The apparatus of any of claims 1 to 8, wherein the first substrate comprises one of an active IC die, a passive IC die, or an interposer, and the second substrate comprises a monolithic material.

10. The apparatus of any of claims 1 to 9, wherein the composite metal structures comprise a portion of a hybrid bond between the second interconnect layer of the IC and the first interconnect layer of the first substrate, the hybrid bond further comprising a second inorganic layer between the second interconnect layer of the IC die and the first interconnect layer of the first substrate.

11. An apparatus, comprising:
a first substrate comprising a first interconnect layer;
an integrated circuit (IC) die comprising a second interconnect layer and a backside surface opposite the second interconnect layer, wherein the second interconnect layer of the IC die is coupled to the first interconnect layer of the first substrate by composite metal structures therebetween;
a second substrate coupled to the backside surface of the IC die by an inorganic layer on the backside surface of the IC die and the second substrate; and
one or more structures extending around an outer perimeter of the inorganic layer, wherein the one or more structures comprise a layer of material having an atomic composition of at least ten percent carbon or at least ten percent fluorine.

12. The apparatus of claim 11, wherein the layer of material comprises a layer of hydrophobic material.

13. The apparatus of claim 11 or 12, wherein the layer of material extends from the backside surface of the IC die to the second substrate.

14. The apparatus of any of claims 11 to 13, wherein the outer perimeter of the inorganic layer is fully within an outer perimeter of the IC die.

15. The apparatus of claim 14, wherein an outer perimeter of the one or more structures is fully within the outer perimeter of the IC die.
